(19) **Europäisches Patentamt European Patent Office Office européen des brevets**

(11) **EP 3 370 266 B1**

(12) **EUROPEAN PATENT SPECIFICATION**

(45) Date of publication and mention of the grant of the patent:
**17.06.2020 Bulletin 2020/25**

(21) Application number: **16859987.6**

(22) Date of filing: **28.10.2016**

(51) Int Cl.:
***H01L 33/08*** *(2010.01)*  ***H01L 33/36*** *(2010.01)*
***H01L 27/00*** *(2006.01)*  ***H01L 25/00*** *(2006.01)*

(86) International application number:
**PCT/JP2016/082141**

(87) International publication number:
**WO 2017/073759 (04.05.2017 Gazette 2017/18)**

(54) **LIGHT-EMITTING ELEMENT, LIGHT RECEIVING AND EMITTING ELEMENT MODULE, AND OPTICAL SENSOR**

LICHTEMITTIERENDES ELEMENT, LICHTEMPFANGENDES UND EMITTIERENDES ELEMENTMODUL UND OPTISCHER SENSOR

ÉLÉMENT ÉLECTROLUMINESCENT, MODULE D'ÉLÉMENTS RÉCEPTEURS ET ÉMETTEURS DE LUMIÈRE, ET CAPTEUR OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.10.2015 JP 2015212483**
**18.12.2015 JP 2015247117**

(43) Date of publication of application:
**05.09.2018 Bulletin 2018/36**

(73) Proprietor: **Kyocera Corporation**
**Kyoto-shi**
**Kyoto 612-8501 (JP)**

(72) Inventors:
• **KISHIMOTO, Tatsuya**
**Kyoto-shi**
**Kyoto 612-8501 (JP)**
• **FUJIMOTO, Naoki**
**Kyoto-shi**
**Kyoto 612-8501 (JP)**

• **ANZAKI, Toshihiro**
**Kyoto-shi**
**Kyoto 612-8501 (JP)**
• **UEHARA, Kenji**
**Kyoto-shi**
**Kyoto 612-8501 (JP)**

(74) Representative: **Viering, Jentschura & Partner mbB**
**Patent- und Rechtsanwälte**
**Am Brauhaus 8**
**01099 Dresden (DE)**

(56) References cited:
**JP-A- H04 207 079**   **JP-A- 2003 031 858**
**JP-A- 2003 347 589**   **JP-A- 2006 005 215**
**JP-A- 2010 056 488**   **JP-A- 2013 072 843**
**JP-A- 2013 115 245**   **JP-A- 2015 060 998**
**KR-A- 20110 098 600**   **KR-A- 20110 121 178**
**US-A1- 2013 306 997**

**Description**

Technical Field

The present invention relates to a light-emitting device, a light receiving and emitting device module, and an optical sensor.

Background Art

There is a heretofore known lateral-type light-emitting device comprising a cathodic electrode and an anodic electrode arranged on an upper surface of a light-emitting section and at a location laterally displaced from the light-emitting section, respectively (Light Emitting Diode, or LED for short).

In connection with such a lateral LED, for example, a proposal has been made in Japanese Unexamined Patent Publication JP-A 2007-281426 about the use of a narrow elongate anodic electrode which is disposed on the upper surface of a light-emitting device for the purpose of improving evenness in light emission (Patent Literature 1). Document KR 2011 0098600 discloses a LED device comprising a plurality of light emitting regions formed as a grid on a first semiconductor region.

Summary of Invention

A light-emitting device according to claim 1.

Brief Description of Drawings

FIG. 1 is a sectional view showing a vertical section of a light-emitting device according to one embodiment of the invention;
FIG. 2 is a top view of the light-emitting device shown in FIG. 1;
FIG. 3 is a top view showing the light-emitting device not forming part of the invention;
FIG. 4 is a top view, with parts omitted, showing the light-emitting device shown in FIG. 3;
FIG. 5 is a top view showing the light-emitting device according to one embodiment of the invention;
FIG. 6 is a top view, with parts omitted, showing the light-emitting device shown in FIG. 5;
FIG. 7 is a top view showing the light-emitting device according to one embodiment of the invention;
FIG. 8 is a top view, with parts omitted, showing the light-emitting device shown in FIG. 7;
FIG. 9 is a sectional view showing a vertical section of a light-emitting device shown in FIG. 7;
FIG. 10 is a top view showing the light-emitting device according to one embodiment of the invention;
FIG. 11 is a top view, with parts omitted, showing the light-emitting device shown in FIG. 10;
FIG. 12 is a top view showing the light-emitting device according to one embodiment of the invention;
FIG. 13 is a top view, with parts omitted, showing the light-emitting device shown in FIG. 12;
FIG. 14 is a sectional view showing a vertical section of a light receiving and emitting device module according to one embodiment of the invention;
FIG. 15 is a sectional view showing a vertical section of an optical sensor according to one embodiment of the invention;
FIG. 16 is a graph showing an example of output from a light-receiving device in the optical sensor shown in FIG. 15;
FIG. 17 is a top view schematically showing a light receiving and emitting device module according to one embodiment of the invention; and
FIG. 18 is an explanatory view of the light-emitting device according to one embodiment of the invention.

Description of Embodiments

The following describes a light emitting device, a light receiving and emitting device module, and an optical sensor according to one embodiment of the invention with reference to the drawings. It is noted that Cartesian coordinate system (X, Y, Z coordinates) is defined in each drawing, and, in what follows, a positive direction along the Z axis corresponds to an upward direction. Moreover, as employed in the present description, the term "upward (direction)" refers to the direction of emission of light from a light-emitting device.

<Light-emitting device>

<First Embodiment>

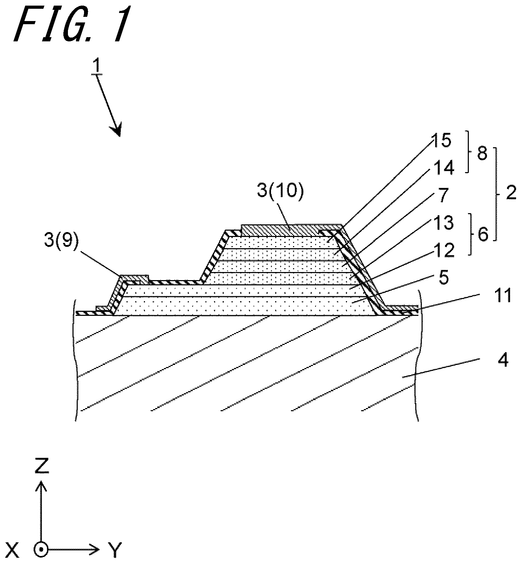

A light-emitting device 1 emits light under the passage of electrical current therethrough. As shown in FIG. 1, the light-emitting device 1 comprises a plurality of semiconductor layers 2, and a plurality of electrodes 3 electrically connected to the plurality of semiconductor layers 2. In the light-emitting device 1 thus constructed, the application of a voltage to the plurality of semiconductor layers 2 via the plurality of electrodes 3 allows part of the plurality of semiconductor layers 2 to emit light.

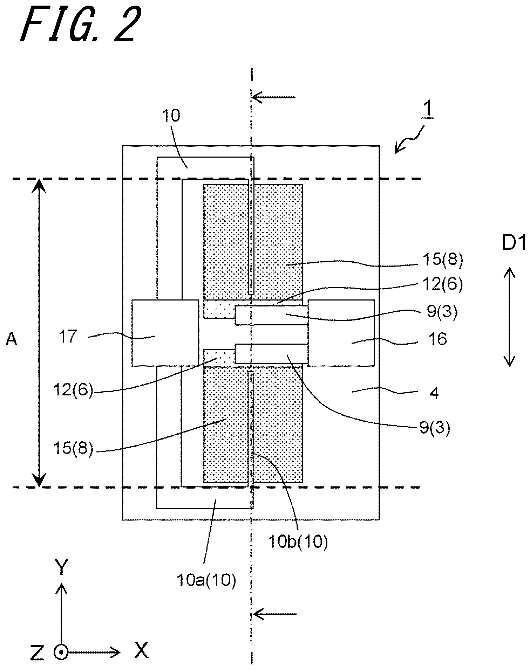

FIG. 1 shows part of the section of the light-emitting device 1 taken along the line I-I of FIG. 2.

The light-emitting device 1 is supported on a substrate 4. For example, the substrate 4 is a semiconductor substrate. The substrate 4 is formed of silicon (Si) or gallium arsenide (GaAs), for example. For example, the substrate 4 can be formed by slicing a silicon (Si) ingot into a wafer. The substrate 4 of this example is a silicon (Si) substrate.

The plurality of semiconductor layers 2 of the light-emitting device 1 are laminated on the substrate 4. The plurality of semiconductor layers 2 include a buffer layer 5 laminated on an upper surface of the substrate 4, a first semiconductor layer 6 laminated on an upper surface of the buffer layer 5, an active layer 7 laminated on an upper surface of the first semiconductor layer 6, and a second semiconductor layer 8 laminated on an upper surface of the active layer 7. The first semiconductor layer 6 is of one conductivity type, whereas the second semiconductor layer 8 is of another conductivity type. Each of the plurality of semiconductor layers 2 is rectangular in plan configuration, for example.

Moreover, the plurality of electrodes 3 of the light-emitting device 1 include at least one first electrode 9 and at least one second electrode 10. In the light-emitting device 1 of the present embodiment, the first electrode 9 is connected to the first semiconductor layer 6, and the second electrode 10 is connected to the second semiconductor layer 8. For the purpose of preventing short-circuiting between the plurality of electrodes 3, an insulating layer 11 may be disposed over the surfaces of the plurality of semiconductor layers 2, except for the areas of connection with the plurality of electrodes 3. Moreover, the insulating layer 11 may also be disposed over the upper surface of the substrate 4.

For example, the plurality of electrodes 3 are each formed of gold (Au) or aluminum (Al). For example, the insulating layer 11 is formed of silicon nitride (SiN) or silicon dioxide (SiO$_2$) .

In the following description, one conductivity type corresponds to n type, and the other conductivity type corresponds to p type. However, in the light-emitting device according to the present disclosure, one conductivity type and another conductivity type may be defined as p type and n type, respectively.

The buffer layer 5 can buffer the difference in lattice constant between the substrate 4 and the plurality of semiconductor layers 2. Consequently, it is possible to reduce lattice defects or crystal defects in the plurality of semiconductor layers 2 as a whole. For example, the buffer layer 5 is formed of gallium arsenide (GaAs) .

The first semiconductor layer 6 comprises a first contact layer 12 laminated on the upper surface of the buffer layer 5, and a first clad layer 13 laminated on part of the upper surface of the first contact layer 12. The first electrode 9 of the present embodiment is a cathodic electrode, which is disposed on other part of the upper surface of the first contact layer 12. Moreover, the active layer 7 is laminated on the upper surface of the first clad layer 13.

The first contact layer 12 can decrease the electrical contact resistance with the first electrode 9. For example, the first contact layer 12 is formed of gallium arsenide (GaAs) doped with n-type impurities. Examples of n-type impurities to be added to gallium arsenide (GaAs) include silicon (Si) and selenium (Se).

The first clad layer 13 can confine positive holes in the active layer 7. For example, the first clad layer 13 is formed of aluminum gallium arsenide (AlGaAs) doped with n-type impurities. Examples of n-type impurities to be added to aluminum gallium arsenide (AlGaAs) include silicon (Si) and selenium (Se).

The active layer 7 can emit light under recombination of concentrated electrons and positive holes. For example, the active layer 7 is formed of aluminum gallium arsenide (AlGaAs).

The second semiconductor layer 8 comprises a second clad layer 14 laminated on the upper surface of the active layer 7, and a second contact layer 15 laminated on the upper surface of the second clad layer 14. The second electrode 10 of the present embodiment is an anodic electrode, which is disposed on the upper surface of the second contact layer 15.

The second clad layer 14 can confine electrons in the active layer 7. For example, the second clad layer 14 is formed of aluminum gallium arsenide (AlGaAs) doped with p-type impurities. Examples of doping p-type impurities to be added to aluminum gallium arsenide (AlGaAs) include zinc (Zn) and magnesium (Mg).

The second contact layer 15 can decrease the electrical contact resistance with the second electrode 10. For example, the second contact layer 15 is formed of aluminum gallium arsenide (AlGaAs) doped with p-type impurities. The second contact layer 15 is made higher in carrier density than the second clad layer 14 to achieve a decrease in the resistance of contact with the electrode.

For example, the light-emitting device 1 can be formed in accordance with the following procedure. To begin with, the plurality of semiconductor layers 2 are sequentially formed by epitaxial growth on the upper surface of the substrate 4 by MOCVD (Metal Organic Chemical Vapor Deposition), for example. Then, the insulating layer 11 is formed over the surfaces of the plurality of semiconductor layers 2 by P-CVD (Plasma Chemical Vapor Deposition), for example. Subsequently, the plurality of electrodes 3 are each formed on corresponding part of the plurality of semiconductor layers 2 by vapor deposition, sputtering, or plating, for example. The light-emitting device 1 can be formed by following the above-described procedure.

As shown in FIG. 2, the light-emitting device 1 according to the present embodiment, includes a plurality of first semiconductor layers 6 aligned in a first direction D1, a plurality of active layers 7 laminated on the plurality of first semiconductor layers 6, respectively, and a plurality of second semiconductor layers 8 laminated on the plurality of active layers 7, respectively. The light-emitting device 1 further includes a plurality of first electrodes 9 lying between the plurality of active layers 7. Moreover, a plurality of second electrodes 10 are disposed on the plurality of second semiconductor layers 8, respectively.

Although not shown in FIG. 2, the plurality of active layers 7 are each laminated on corresponding one of the plurality of first semiconductor layers 6 aligned in the first direction D1, from which it follows that the active layers 7 are also aligned in the first direction D1. Moreover, for the purpose of convenience in explanation, in FIG. 2, the insulating layer 11 is omitted from the construction.

Moreover, at least one second electrode 10 comprises a plurality of second electrodes 10, which are opposed to each other. The plurality of active layers 7 are located in a region between the plurality of opposed second electrodes 10. More specifically, the plurality of second electrodes 10 of the present embodiment are routed from one location while being bent on their ways so as to be opposed to each other. Thus, the plurality of active layers 7 are located in a region where the plurality of second electrodes 10 are opposed to each other (the region between the plurality of second electrodes 10).

It has heretofore been believed that unevenness of light emission from the lateral-type light-emitting device shows up due to lack of uniformity in current diffusion. More specifically, unevenness of light emission from the light-emitting device is ascribable presumably to the length of the anodic electrode. This leads to the presumption that an electrical current passes preferentially through the anodic electrode which is lower in electrical resistance than a p-type semiconductor layer, and will not flow through a plurality of semiconductor layers toward the cathodic electrode until it reaches the front end of the anodic electrode, in consequence whereof there results partial emission of light only from certain locations.

In this regard, the light-emitting device 1 according to the present disclosure has the above-described structure. Put another way, some electrodes of the plurality of electrodes 3 (the plurality of second electrodes 10) are opposed to each other, with the plurality of active layers 7 lying in between, and, the other electrodes of the plurality of electrodes (the plurality of first electrodes 9) are located in the region between that the some electrodes of the plurality of electrodes 3 (the plurality of second electrodes 10). More specifically, the plurality of active layers 7 and the first electrodes 9 are located in the range of confrontation A where the plurality of second electrodes 10 are opposed to each other.

This arrangement makes it possible to reduce unevenness of light emission from the light-emitting device 1 as one light-emitting device 1 composed of the plurality of active layers 7 as a whole. That is, the active layer 7 of the light-emitting device 1 is divided into a plurality of portions, and the second electrode 10 is disposed on each of the separate active layer portions (the plurality of active layers 7), thus allowing each of the separate active layers 7 to emit light effectively. Consequently, it is possible to reduce unevenness of light emission from the light-emitting device 1.

More specifically, the light-emitting device 1 of the present embodiment has two second semiconductor layers 8, and has active layers 7 which are correspondingly two in number. In other words, the active layer 7 is divided into two portions. In this case, of the total area of the plurality of active layers 7, the effectively utilizable area is nearly twice as great as that obtained when the active layer 7 is not divided, which makes it possible to reduce the proportion of a low-light area of the light-emitting device 1, and thereby reduce unevenness of light emission.

As employed herein, "unevenness of light emission" refers to lack of uniformity in light emission observed at a surface of the light-emitting device 1 for the exit of light, and more specifically, for example, part of the light exit surface of the light-emitting device 1 becomes a low-light area which is lower in light emission intensity than other areas. Besides, "improving evenness in light emission" refers to reducing the proportion of the described low-light area to increase the degree of uniformity of light emission.

Moreover, in the light-emitting device 1, the first electrodes 9 are disposed between the plurality of active layers 7. This arrangement makes it possible to increase the current density at the central area of the light-emitting device 1, and thereby enhance the intensity of light emission from the central area. Hence, although there is no emission of light from between the plurality of active layers 7, the enhancement of the intensity of light emission from the area including the region between the plurality of active layers 7 makes it possible to reduce unevenness of light emission from the light-emitting device 1 as a whole.

The plurality of first electrodes 9 are provided in a linear form in the region between the plurality of active layers 7. This facilitates bringing uniformity in current diffusion between the first electrode 9 and the second electrode 10, and thus can reduce unevenness of light emission.

The plurality of second electrodes 10 may further include a plurality of principal portions 10a each extending in an elongation direction of the first electrode 9, and a plurality of extended portions 10b each extending from corresponding one of the plurality of principal portions 10a toward the first electrode 9, as seen in top view. Consequently, it is possible to increase current density between the first electrode 9 and the front end of each of the plurality of extended portions 10b. In the case where the second electrodes 10 include the principal portions 10a and the extended portions 10b, parts of the plurality of electrodes 3 opposed to each other, with the plurality of active layers 7 lying in between correspond to one ends of the principal portions 10a.

The plurality of principal portions 10a may be disposed on the substrate 4. That is, the plurality of principal portions 10a are not necessarily required to make connection with the plurality of semiconductor layers 2. Consequently, it is possible to reduce the area of the plurality of second electrodes 10 located on the plurality of second semiconductor layers 8, respectively, and thereby reduce unevenness of light emission from the light-emitting device 1. In the case where the insulating layer 11 is disposed over the upper surface of the substrate 4, the plurality of principal portions 10a are disposed, through the insulating layer 11, on the upper surface of the substrate 4.

Each of the plurality of extended portions 10b may be made smaller in width than each of the plurality of principal portions 10a. Consequently, it is possible to reduce the area of the second electrode 10 situated on the second semiconductor layer 8, and thereby reduce unevenness of light emission from the light-emitting device 1.

On the substrate 4, a first electrode pad 16 and a second electrode pad 17 are disposed. The first electrode pad 16 and the second electrode pad 17 make connection with the first electrode 9 and the plurality of second electrodes 10, respectively, for electrical conduction.

In the light-emitting device according to the present disclosure, the plurality of electrodes 3 may include the plurality of first electrodes 9 or the plurality of second electrodes 10, and, in this case, all of the plurality of first electrodes 9 or all of the plurality of second electrodes 10 may be connected to the first electrode pad 16 or the second electrode pad 17. Consequently, it is possible to concurrently operate the plurality of active layers 7, and it is easy to make the plurality of active layers 7 function as one light-emitting device 1.

Moreover, as described above, connecting the first electrode pad 16 to the first electrode 9, as well as connecting the second electrode pad 17 to the second electrode 10, permits a parallel connection of the plurality of active layers 7. That is, an increase in junction temperature can be suppressed, wherefore application of higher current can be achieved. Thus, it is possible to provide the light-emitting device 1 which exhibits high light emission intensity.

Meanwhile, a plurality of first electrode pads 16 or a plurality of second electrode pads 17 may be disposed on the upper surface of the substrate 4. In this case, the plurality of electrodes 3 may include the plurality of first electrodes 9 or the plurality of second electrodes 10, and each of the plurality of first electrodes 9 or each of the plurality of second electrodes 10 may be connected to corresponding one of the plurality of first electrode pads 16 or corresponding one of the plurality of second electrode pads 17. In other words, the plurality of first electrodes 9 or the plurality of second electrodes 10 may be electrically independent of each other. Consequently, it is possible to make part of the plurality of active layers 7 to emit light, or make the plurality of active layers 7 to emit light one after another. Thus, the light-emitting device 1 can be operated differently according to applications.

In the case where the insulating layer 11 is disposed over the upper surface of the substrate 4, the first electrode pad 16, the second electrode pad 17, and the plurality of electrodes 3 mounted on the substrate 4 may be placed, through the insulating layer 11, on the substrate 4.

The first electrode pad 16 and the second electrode pad 17 may be formed of gold (Au) or aluminum (Al) in combination with nickel (Ni), chromium (Cr), or titanium (Ti) serving as an adherent layer, such as AuNi alloy, AuCr alloy, AuTi alloy, or AlCr alloy.

<Second Embodiment not forming part of the invention>

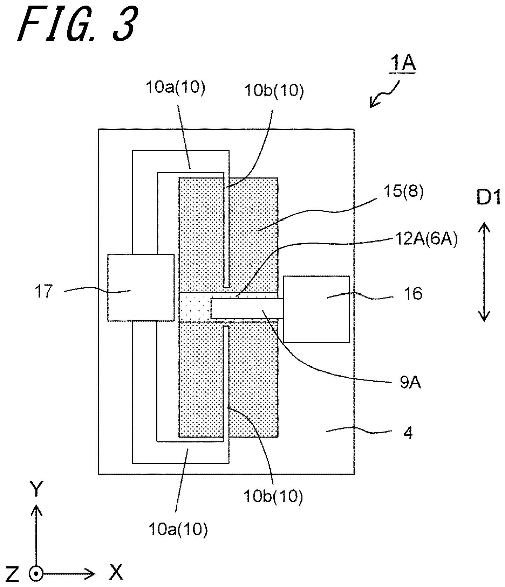

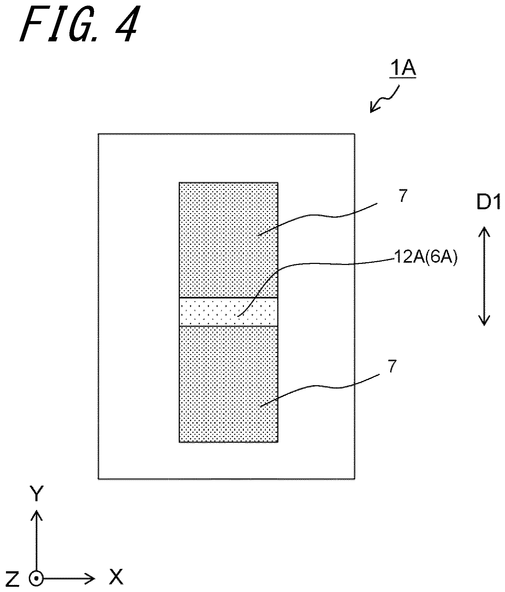

FIGS. 3 and 4 each show a top view of a light-emitting device 1A according to a second embodiment not forming part of the invention. For the purpose of convenience in explanation, in FIG. 3, the insulating layer 11 is omitted from the construction. Moreover, in FIG. 4, a second semiconductor layer 8, a first electrode 9A, a plurality of second electrodes 10, a first electrode pad 16, and a second electrode pad 17 are omitted from the light-emitting device 1A shown in FIG. 3 to bring the arrangement of a plurality of active layers 7 into view.

The light-emitting device 1A differs from another embodiment in that it has one first semiconductor layer 6A and one first electrode 9A. In the light-emitting device 1A, the first electrode 9A is common to the plurality of active layers 7. More specifically, one buffer layer 5A and one first contact layer 12A common to the plurality of active layers 7 are disposed on the substrate 4.

In the light-emitting device 1A thus constructed, the plurality of active layers 7 can be arranged close to each other. Consequently, it is possible to reduce a decrease in the intensity of light emission from the central area of the light-emitting device 1A.

Moreover, in this case, the plurality of extended portions 10b constituting the plurality of second electrodes 10 may be symmetrical with respect to a line defined by the first electrode 9A as an axis. Consequently, it is possible to reduce unevenness of light emission from the light-emitting device 1A.

<Third Embodiment>

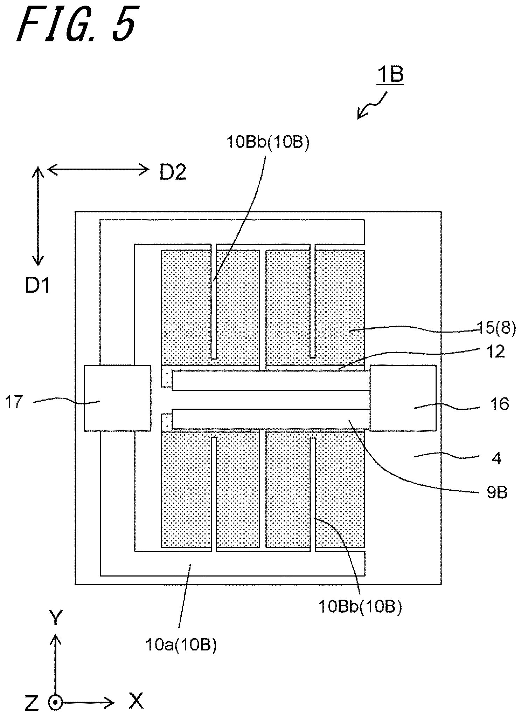

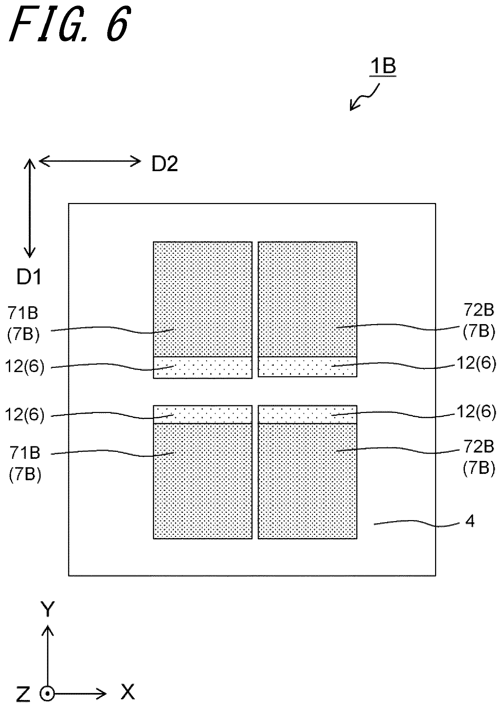

FIGS. 5 and 6 each show a top view of a light-emitting device 1B according to a third embodiment. For the purpose of convenience in explanation, in FIG. 5, the insulating layer 11 is omitted from the construction. Moreover, in FIG. 6, a second semiconductor layer 8, a plurality of first electrodes 9, a plurality of second electrodes 10B, a first electrode pad 16, and a second electrode pad 17 are omitted from the light-emitting device 1B shown in FIG. 5 to bring the arrangement of a plurality of active layers 7B into view.

The light-emitting device 1B differs from another embodiment in that the plurality of active layers 7B include a plurality of first active layers 71B aligned in a first direction D1, and a plurality of second active layers 72B, each being arranged adjacent to corresponding one of the plurality of first active layers 71B in a second direction D2 which is perpendicular to the first direction D1. Note that the plurality of second active layers 72B are aligned in the first direction D1. In other words, in the light-emitting device 1B, the plurality of active layers 7B are arranged in a matrix pattern.

The light-emitting device 1B comprises, as a plurality of electrodes 3B, the plurality of first electrodes 9 and the plurality of second electrodes 10B. The plurality of first electrodes 9 may be located on the center side of a structure composed of an aggregate of the plurality of active layers 7B. The plurality of second electrodes 10B may be located on the outer side of the structure. With this arrangement, even if the light emission area is increased, it is possible to reduce the occurrence of unevenness in light emission, and provide the light-emitting device 1B capable of reducing a decrease in the intensity of light emission from the central area of the device. Note that the plurality of second electrodes 10B include a plurality of extended portions 10Bb, the number of which conforms to the number of the plurality of active layers 7B. Moreover, instead of the plurality of first electrodes 9, one first electrode may be disposed.

Moreover, the distance between the plurality of first active layers 71B is longer than the distance between each of the plurality of first active layers 71B and corresponding one of the plurality of second active layers 72B. Consequently, it is possible to reduce the area of a non-emitting region of the light-emitting device 1B, and thereby reduce unevenness of light emission.

Moreover, each of the plurality of first electrodes 9 is not necessarily required to lie between each of the plurality of first active layers 71B and corresponding one of the plurality of second active layers 72B. Consequently, it is possible to reduce the distance between each of the plurality of first active layers 71B and corresponding one of the plurality of second active layers 72B effectively.

Moreover, each of the plurality of first electrodes 9 may be disposed so as to be intersected by a virtual line extending from the tip of each of the plurality of extended portions 10Bb constituting the plurality of second electrodes 10B in the longitudinal direction of each extended portion 10Bb. Consequently, it is possible to reduce unevenness of light emission from the light-emitting device 1B.

Although, in this example, the light-emitting device has two rows of constituent layers in the second direction, three or more rows may be placed instead.

<Fourth Embodiment>

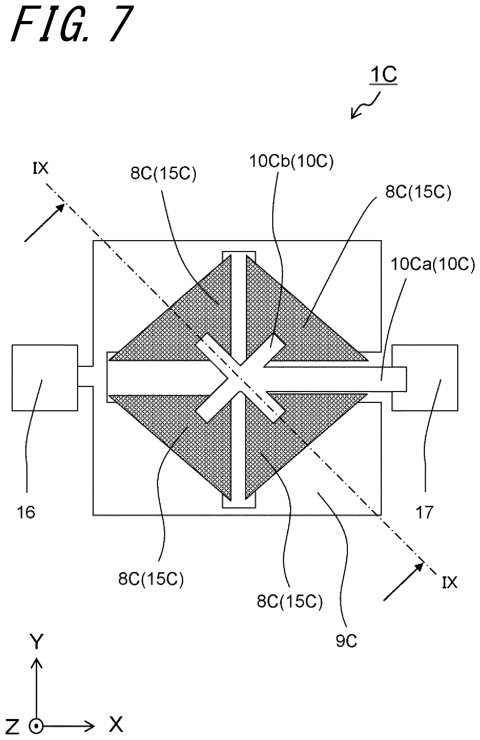

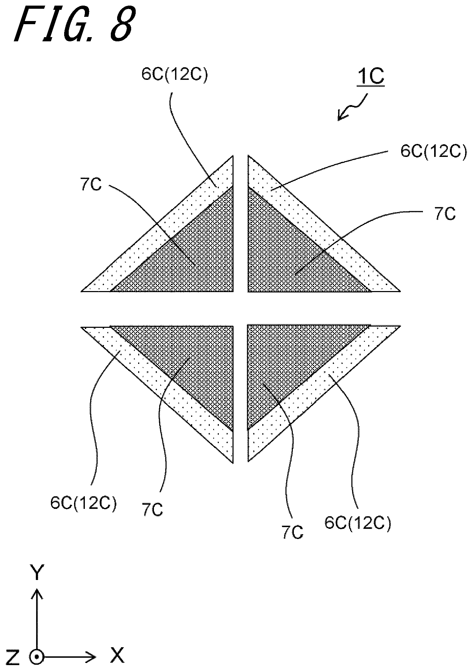

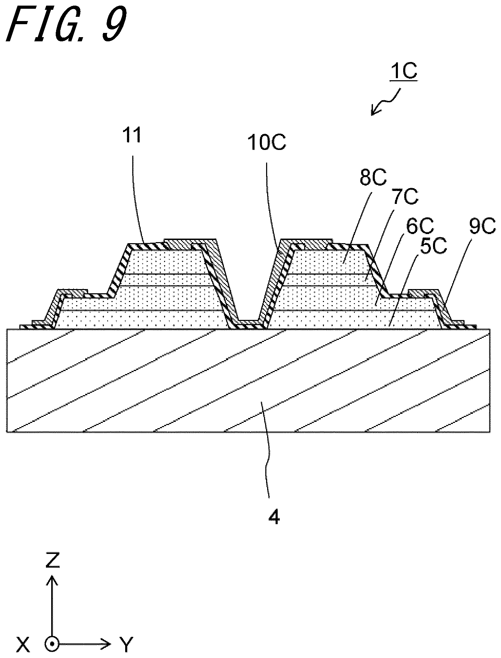

FIGS. 7, 8 and 9 each show a top view of a light-emitting device 1C according to a fourth embodiment. For the purpose of convenience in explanation, in FIG. 7, the substrate 4 and the insulating layer 11 are omitted from the construction. Moreover, in FIG. 8, a second semiconductor layer 8C, a first electrode 9C, a plurality of second electrodes 10C, a first electrode pad 16, and a second electrode pad 17 are omitted from the light-emitting device 1C shown in FIG. 7 to bring the arrangement of a plurality of active layers 7C into view. Moreover, FIG. 9 shows the section of the light-emitting device 1C shown in FIG. 7 taken along the line IX-IX of FIG. 7.

The light-emitting device 1C differs from other embodiment in that it has a plurality of active layers 7C, each of which is triangular in plan configuration. Moreover, the plurality of active layers 7C are arranged with their sides opposed to one another as seen in top view, so that the plurality of active layers 7C define a rhombus pattern as a whole. Note that, in the present embodiment, a plurality of second semiconductor layers 8C are each also triangular in plan configuration. Moreover, in the present embodiment, a plurality of first semiconductor layers 6C are each also triangular in plan configuration. Note that the plan configuration of each layer is not limited to a triangular shape.

Moreover, in the light-emitting device 1C, a plurality of electrodes 3C include a plurality of first electrodes 9C and second electrodes 10C. The plurality of first electrodes 9C are arranged so as to surround the plurality of active layers 7C. The second electrodes 10C include a principal portion 10Ca disposed between the plurality of active layers 7C, and an extended portion 10Cb extending inwardly from the vertex of each of the plurality of second semiconductor layers 8C.

<Fifth Embodiment>

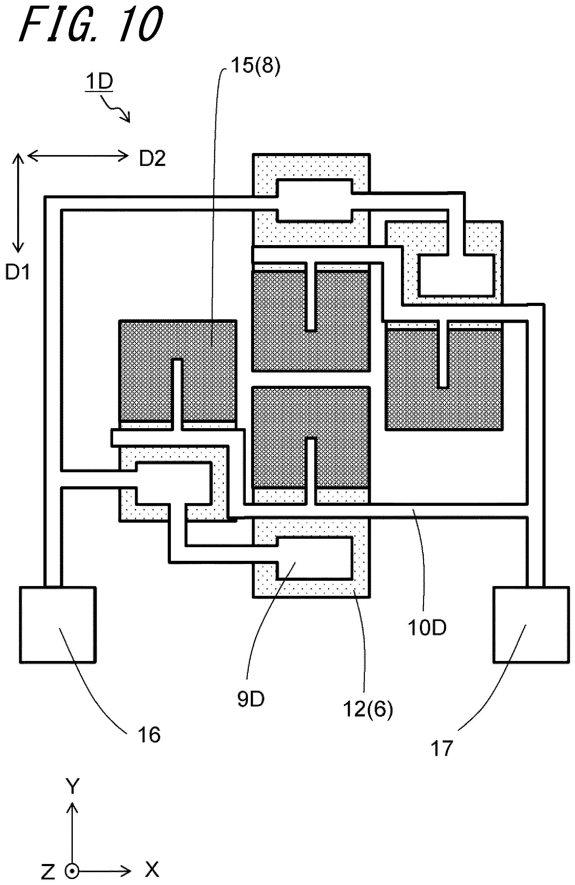

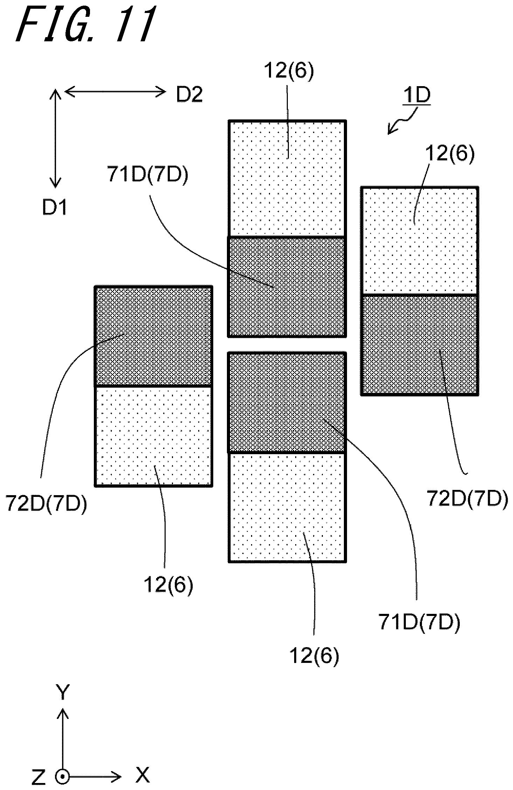

FIGS. 10 and 11 each show a top view of a light-emitting device 1D according to a fifth embodiment. For the purpose of convenience in explanation, in FIG. 10, the substrate 4 and the insulating layer 11 are omitted from the construction. Moreover, in FIG. 11, a second semiconductor layer 8, a first electrode 9D, a plurality of second electrodes 10D, a first electrode pad 16, and a second electrode pad 17 are omitted from the light-emitting device 1D shown in FIG. 10 to bring the arrangement of a plurality of active layers 7D into view.

The light-emitting device 1D differs from other embodiment in that the plurality of active layers 7D include a plurality of first active layers 71D aligned in a first direction D1, and a plurality of second active layers 72D aligned in a second direction D2 which is perpendicular to the first direction D1, with the plurality of first active layers 71D lying in between.

Moreover, in the light-emitting device 1D, a plurality of electrodes 3D include a plurality of first electrodes 9D and second electrodes 10D. The plurality of first electrodes 9D and the plurality of second electrodes 10D are arranged so that the plurality of first active layers 71D are sandwiched between the first and second electrodes. Consequently, it is possible to place the plurality of first active layers 7D with higher packing density.

<Sixth Embodiment>

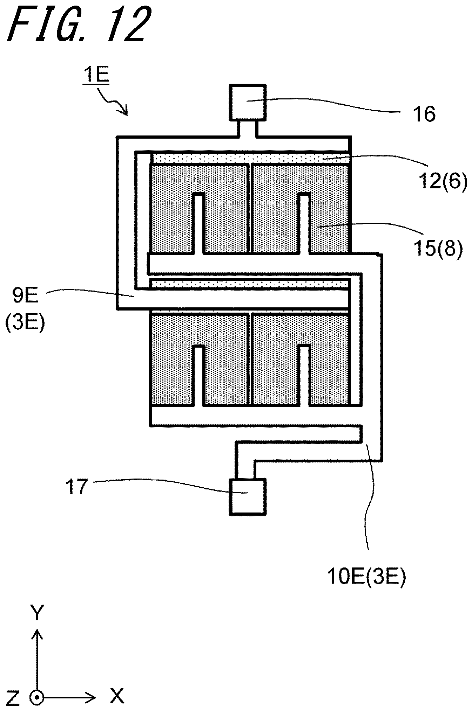

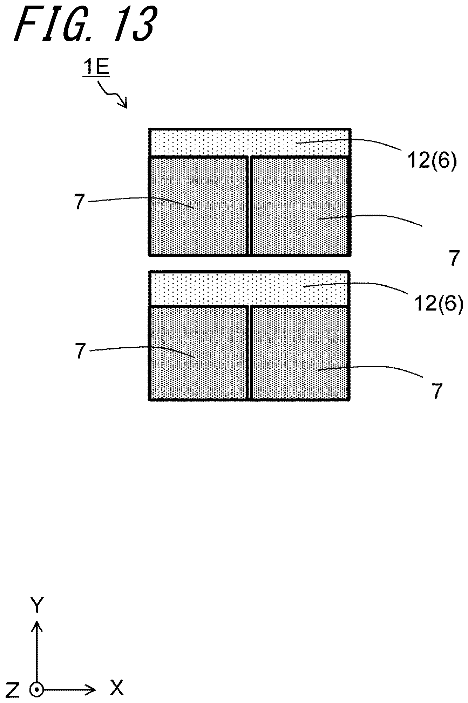

FIGS. 12 and 13 each show a top view of a light-emitting device 1E according to a sixth embodiment. For the purpose of convenience in explanation, in FIG. 12, the substrate 4 and the insulating layer 11 are omitted from the construction. Moreover, in FIG. 13, a second semiconductor layer 8, a first electrode 9E, a plurality of second electrodes 10E, a first electrode pad 16, and a second electrode pad 17 are omitted from the light-emitting device 1E shown in FIG. 12 to bring the arrangement of a plurality of active layers 7 into view.

In the light-emitting device 1E, a plurality of electrodes 3E include a plurality of first electrodes 9E and a plurality of second electrodes 10E. One of the plurality of first electrodes 9E and one of the plurality of second electrodes 10E are arranged so that a plurality of active layers 7E are sandwiched between the first and second electrodes. The light-emitting device 1E differs from another embodiment in that the other one of the plurality of first electrodes 9E and the other one of the plurality of second electrodes 10E are disposed between the plurality of active layers 7. That is, the light-emitting device 1E differs from another embodiment in that, in the region between some electrodes of the plurality of electrodes 3E (between one of the plurality of first electrodes 9E and one of the plurality of second electrodes 10E), there are provided the plurality of active layers 7 and the other electrodes of the plurality of electrodes 3E (the other one of the plurality of first electrodes 9E and the other one of the plurality of second electrodes 10E).

<Light receiving and emitting device module>

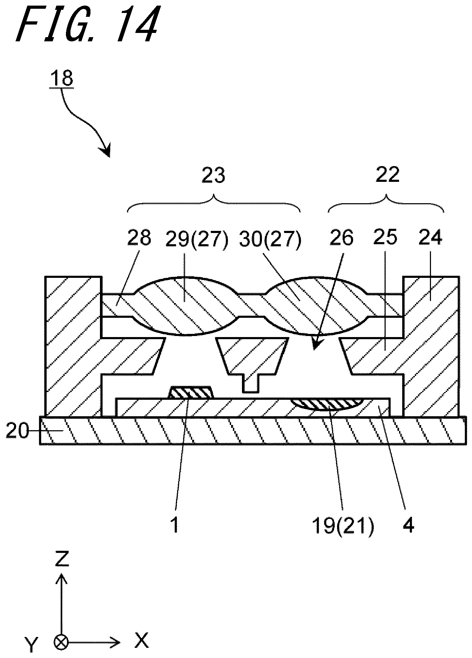

FIG. 14 shows a schematic view of a light receiving and emitting device module 18.

The light receiving and emitting device module 18 comprises the above-described light-emitting device 1, a light-receiving device 19, and a wiring substrate 20 on which the light-emitting device 1 and the light-receiving device 19 are mounted. In the light receiving and emitting device module 18, light is applied from the light-emitting device 1 to an irradiation target (not shown), and the reflected light from the irradiation target is received by the light-receiving device 19, thus enabling sensing of the irradiation target. Hence, as will hereafter be described, the light receiving and emitting device module 18 is incorporated in an image forming apparatus such for example as a copying machine or a printer for detection of information about the irradiation target such as a toner or media, including positional data, distance data, and concentration data.

The light-receiving device 19 is formed on the substrate 4 supporting the light-emitting device 1. More specifically, the substrate 4 according to the present embodiment is formed of a semiconductor material of one conductivity type. For example, an n-type silicon (Si) substrate is used for the substrate 4. That is, the substrate 4 is constructed of a silicon (Si) substrate doped with n-type impurities. Examples of n-type impurities to be added to the silicon (Si) substrate include phosphorus (P) and nitrogen (N).

The light-receiving device 19 is formed by disposing a semiconductor region 21 of another conductivity type in a region on the upper surface of the substrate 4 spaced away from the light-emitting device 1. That is, on the substrate 4 of one conductivity type, the semiconductor region 21 of another conductivity type is formed to obtain a p-n junction, thus forming the light-receiving device 19. The semiconductor region 21 of another conductivity type can be formed by doping the substrate 4 with p-type impurities. The substrate 4 is, as exemplified, constructed of a silicon (Si) substrate, wherefore examples of the p-type impurities include boron (B), zinc (Zn), and magnesium (Mg).

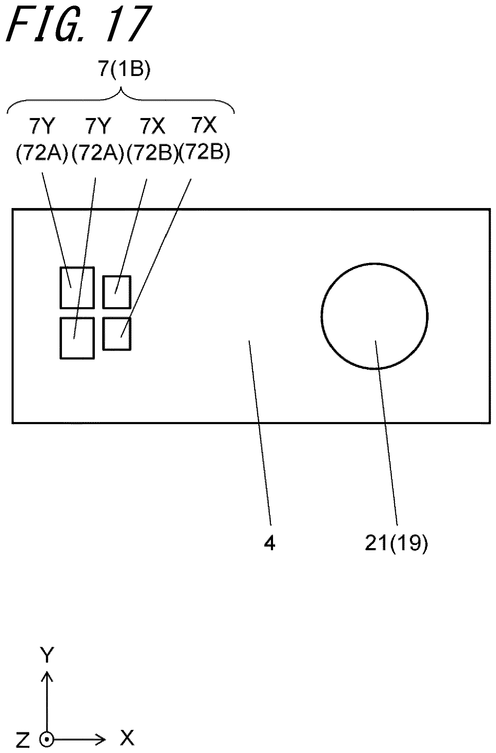

For example, the semiconductor region 21 is polygonal or circular in plan configuration. It is desirable that, as shown in FIG. 17, the semiconductor region 21 has a circular shape. It is more desirable that the semiconductor region 21 has a true circular shape. The plan configuration of the semiconductor region 21 refers to the contour of the semiconductor region 21 as seen from above the upper surface of the substrate 4.

For example, where the light receiving and emitting device module 18 in the present embodiment is mounted, as an optical sensor 31 which will hereafter be described, in an image forming apparatus for registration purposes, in some cases, registration is effected on the basis of the result of comparison between an output waveform at the current value of the light-receiving device 19 and a predetermined waveform. At this time, for example, when the semiconductor region 21 is polygonal in plan configuration, corner positions of a polygon which defines the plan configuration of the semiconductor region 21 may be deviated due to manufacturing variation. This results in a deviation of the output waveform at the current value of the light-receiving device 19 from the predetermined waveform even if registration marks are printed in correct positions, and consequently, in spite of the registration, the possibility of registration mark misalignment arises.

In this regard, by making the semiconductor region 21 circular (truly circular, in particular) in plan configuration, in contrast to the case of making it rectangular in plan configuration, it is possible to reduce manufacturing variation in the direction of rotation about an axis of rotation defined by an axis extending from the center of the semiconductor region 21 in the normal direction of the substrate 4, and thereby increase the accuracy of registration.

The light-receiving device 19 may be made smaller in size than the irradiation target. That is, the planar area of the light-receiving device 19 is smaller than the planar area of the irradiation target. For example, where the light receiving and emitting device module 18 of the present embodiment is used for registration, in light of the fact that the dimension of a registration mark is generally greater than or equal to 2 mm but less than or equal to 15 mm, the dimension of one side of the light-receiving device 19 is adjusted to be greater than or equal to 0.5 mm but less than or equal to 10 mm, for example.

Instead of the light-receiving device 19, the light-emitting device 1 may be made circular in plan configuration, or a light passage portion 26, which will hereafter be described, may be made circular in plan configuration. Moreover, the diameter of the light-emitting device 1 or the light passage portion 26 in circular form is adjusted to be substantially equal to the above-described dimension of one side of the light-receiving device.

In the plurality of active layers 7, when the adjacent active layers 7 are compared, an area of an upper surface of one of them located close to the light-receiving device 19 may be smaller than an area of an upper surface of the other active layer 7. In the light-emitting device 1B shown in FIG. 6 taken up as an example, an area of an upper surface of the second active layer 72B located close to the light-receiving device 19 may be smaller than an area of an upper surface of the opposite first active layer 71A.

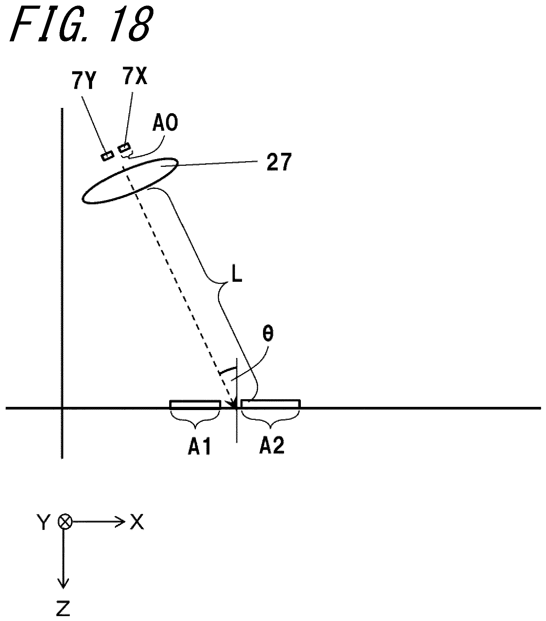

As shown in FIG. 18, the light emitted from the second active layer 72B located close to the light-receiving device 19 (hereafter referred to as "a plurality of third active layers 7X") and the light emitted from the opposite first active layer 71A (hereafter referred to as "a plurality of fourth active layers 7Y") differ from each other in optical path length, and therefore reach the irradiation target with different areas of light application. Consequently, a difference between an output waveform at the rise time and an output waveform at the fall time under the current value of the light-receiving device 19 is liable to occur, and the accuracy of registration tends to be decreased, for example,

Thus, by forming the plurality of active layers 7 in the above-described configuration, it is possible to make the areas of light spots on the irradiation target close to each other, and thus the accuracy of registration can be increased, for example.

The following are specific explanations.

As shown in FIG. 18, for example, when Ao denotes the area of the upper surface of each of the plurality of third active layers 7X, K denotes the magnification for the irradiation target, L denotes the projection distance, and $\theta$ denotes the angle of incidence, the irradiation area of light from the plurality of third active layers 7X ($A_2$) can be represented by the following mathematical expression.

[Formula 1]

$$A_2 = \frac{KA_0 \cos\theta + KA_0 \tan\theta \cdot \cos\theta \cdot \tan(90 + \theta - \arctan(2L/A_0(K-1)))}{2} \cdots (1)$$

Moreover, for example, when $A_0$ denotes the area of the upper surface of each of the plurality of fourth active layers 7Y, K denotes the magnification for the irradiation target, L denotes the projection distance, and $\theta$ denotes the angle of incidence, the irradiation area of light from the plurality of fourth active layers 7Y ($A_1$) can be represented by the following mathematical expression.

[Formula 2]

$$A_1 = \frac{KA_0 \cos\theta}{2} + \frac{KA_0 \tan\theta \cdot \cos\theta}{2\tan(180 - \theta - \arctan(2L/A_0(K-1)))} \cdots (2)$$

The difference between the irradiation area of light from the plurality of third active layers 7X ($A_2$) and the irradiation area of light from the plurality of fourth active layers 7Y ($A_1$) can be represented by the following mathematical expression.
[Formula 3]

$$A_2 - A_1 = KA \tan\theta \cdot \cos\theta \left\{ \frac{\tan(90 + \theta - \arctan(2L/A_0(K-1)))}{2} - \frac{1}{2\tan(180 - \theta - \arctan(2L/A_0(K-1)))} \right\} \cdots (3)$$

That is, the irradiation area of light from the plurality of third active layers 7X ($A_2$) is greater than the irradiation area of light from the plurality of fourth active layers 7Y ($A_1$) by an amount corresponding to the value derived from the described mathematical expression (3). Thus, to make the irradiation area of light from the plurality of third active layers 7X ($A_2$) close to the irradiation area of light from the plurality of fourth active layers 7Y ($A_1$), the area of the upper surface of each of the plurality of third active layers 7X needs to be reduced with respect to the area of the upper surface of each of the plurality of fourth active layers 7 by an amount corresponding to the value derived from the following mathematical expression (4), namely the value obtained by dividing the value derived from the following mathematical expression (3) by the magnification K for the irradiation target.
[Formula 4]

$$\frac{A_2 - A_1}{K} = A \tan\theta \cdot \cos\theta \left\{ \frac{\tan(90 + \theta - \arctan(2L/A_0(K-1)))}{2} - \frac{1}{2\tan(180 - \theta - \arctan(2L/A_0(K-1)))} \right\} \cdots (4)$$

For example, the area of the upper surface of each of the plurality of third active layers 7X and the area of the upper surface of each of the plurality of fourth active layers 7 are each adjusted to be greater than or equal to $9 \times 10^{-10}$ m$^2$ but less than or equal to $2.5 \times 10^{-5}$ m$^2$. Moreover, for example, the area of spot light is adjusted to be greater than or equal to $2.25 \times 10^{-8}$ m$^2$ but less than or equal to $4 \times 10^{-6}$ m$^2$. Furthermore, the area of the upper surface of each of the plurality of third active layers 7X is adjusted to be not more than 0.1 time and not less than 0.99 time the area of the upper surface of each of the plurality of fourth active layers 7.

Although "the second active layer 72B located close to the light-receiving device 19" is represented as "the plurality of third active layers 7X" in the above explanations, in this description, "the plurality of third active layers 7X" refers to "the active layer 7 located close to the light-receiving device 19 of the plurality of active layers 7". That is, the plurality of third active layers 7X may include only the plurality of first active layers 71A or include the plurality of second active layers 72B, or may also include both of the first active layer 71A and the second active layer 72B. Similar requirements hold true for the plurality of fourth active layers 7Y.

It is preferable that the distance between the plurality of third active layers 7X and the distance between the plurality of fourth active layers 7Y are substantially equal. This facilitates bringing uniformity in the distribution of quantity of light in the central area of the light-emitting device 1B.

The plurality of fourth active layers 7Y may be made smaller in dimension at the side along a third direction D3 of a conveyer 32 which will hereafter be described than at the side along a fourth direction D4 which is perpendicular to the third direction D3. Consequently, for example, in the case of performing registration process, the duration of time that a registration mark passes through the light-emitting device 1 is prolonged, wherefore the accuracy of registration can be increased.

The wiring substrate 20 is rectangular-shaped, for example. For example, a resin substrate or a ceramic substrate may be used for the wiring substrate 20. The wiring substrate 20 of the present embodiment is constructed of a resin substrate. The wiring substrate 20 can be formed by a heretofore known method.

Moreover, the light receiving and emitting device module 18 further comprises a light shield body 22 and a lens member 23. For example, in order that the light-receiving device 19 will not receive unintended external light (stray light), the light shield body 22 has a function of blocking the stray light. Moreover, the lens member 23 has a function of directing light from the light-emitting device 1 to the irradiation target, as well as directing reflected light from the irradiation target to the light-receiving device 19.

More specifically, the light shield body 22 comprises a frame-shaped wall portion 24 which surrounds the light-emitting device 1 and the light-receiving device 19, and a lid portion 25 formed on the inner surface of the wall portion 24 so as to cover a region surrounded by the wall portion 24. In other words, the light-emitting device 1 and the light-receiving device 19 are housed in the region surrounded by the inner surface of the wall portion 24 and the lower surface of the lid portion 25. Moreover, the light shield body 22 has a plurality of light passage portions 26 through which the light from the light-emitting device 1 passes. The light passage portions 26 according to the present embodiment are defined by a plurality of holes.

Examples of the material for forming the light shield body 22 include resin materials such as polypropylene resin (PP), polyamide resin (PA), polycarbonate resin (PC), and liquid crystal polymer, and metal materials such as aluminum (Al) and titanium (Ti). The light shield body 22 is formed by, for example, injection molding or otherwise.

Moreover, the lens member 23 comprises a lens portion 27 through which light is transmitted, and a support portion 28 which supports the lens portion 27. For example, the lens member 23 is fitted, via the support portion 28, in a region surrounded by the inner surface of the wall portion 24 of the light shield body 22 and the upper surface of the lid portion 25 thereof.

The lens member 23 is formed of a light-transmitting material. Examples of the material for forming the lens member 23 include resin materials such as silicone resin, epoxy resin, and polycarbonate resin, and, sapphire and inorganic glass. The lens member 23 is formed by, for example, injection molding or otherwise.

The lens portion 27 has a function of collecting and guiding emitted light from the light-emitting device 1 and reflected light from the irradiation target. The lens portion 27 comprises a first lens 29 which collects emitted light from the light-emitting device 1, and a second lens 30 which condenses reflected light from the irradiation target. The first lens 29 and the second lens 30 according to the present embodiment are each a convex lens, a spherical lens, or an aspherical lens, for example.

The support portion 28 has a function of supporting the lens portion 27. For example, the support portion 28 is shaped in a plate. The support portion 28 may hold the lens portion 27 by being formed integrally with the lens portion 27, or may hold the lens portion 27 by fitting the first lens 29 and the second lens 30 of the lens portion 27 in the support portion 28.

<Optical sensor>

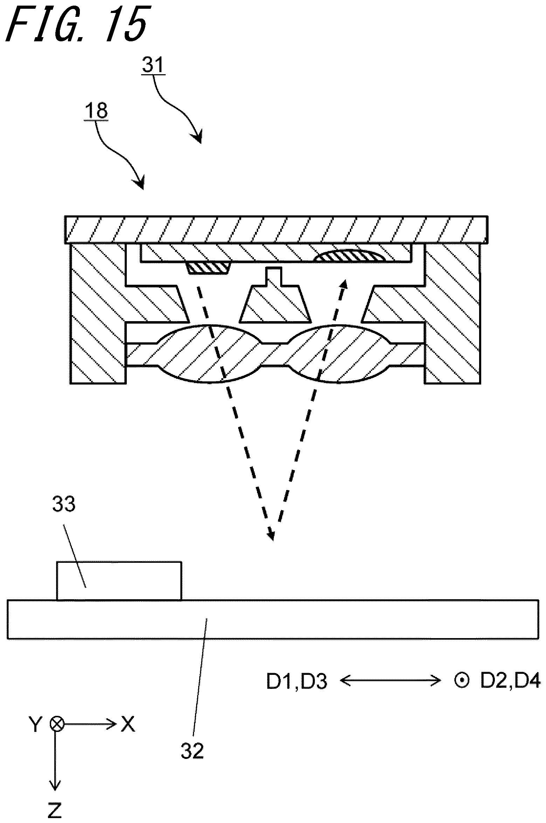

FIG. 15 shows a schematic view of an optical sensor 31.

The optical sensor 31 according to the present embodiment comprises the above-described light receiving and emitting device module 18, and a mount facing the light receiving and emitting device module 18. The mount supports an irradiation target. Moreover, the optical sensor 31 may comprise a mount as an irradiation target. The present embodiment will be described with respect to the case where the optical sensor 31 comprises a conveyer 32 as the mount. The conveyer 32 has a function of conveying an object placed on a surface thereof. Moreover, the surface of the conveyer 32 on which an object (conveyance surface) is placed faces the light-emitting section of the light receiving and emitting device module 18.

The optical sensor 31 according to the present embodiment is mounted on an image forming apparatus such as a copying machine or a printer, a conveyance system such as a belt conveyer or a roller conveyer, FA (Factory Automation) equipment, a scanner, etc. for detection of information about the position of a moving object 33 (irradiation target). For example, the moving object 33 refers to printing paper in the case of the image forming apparatus, and refers to an object under conveyance in the case of the conveyance system. Moreover, the conveyer 32 refers to a transfer belt in the case of the image forming apparatus, and refers to a conveying belt in the case of the conveyance system. As employed herein, "comprising a mount as an irradiation target" corresponds to, for example, the case of detecting the surface conditions, etc. of the conveyer 32 in itself.

The second direction D2, which is perpendicular to the first direction D1 in which are arranged the plurality of active layers 7 of the light receiving and emitting device module 18, is intersected by a conveyance direction D3 by the conveyer 32 (hereafter referred to as "a third direction D3"). In the present embodiment, the first direction D1 coincides with the third direction D3, and the second direction D2 is perpendicular to the third direction D3.

Now, consideration will be given to output fluctuations in the light-receiving device 19 as observed when, for example, the moving object 33 in a state of being conveyed along the third direction while lying on the conveyer 32 passes over the light receiving and emitting device module 18. It is assumed in the following description that the light receiving and emitting device module 18 has two active layers 7 aligned in the first direction D1.

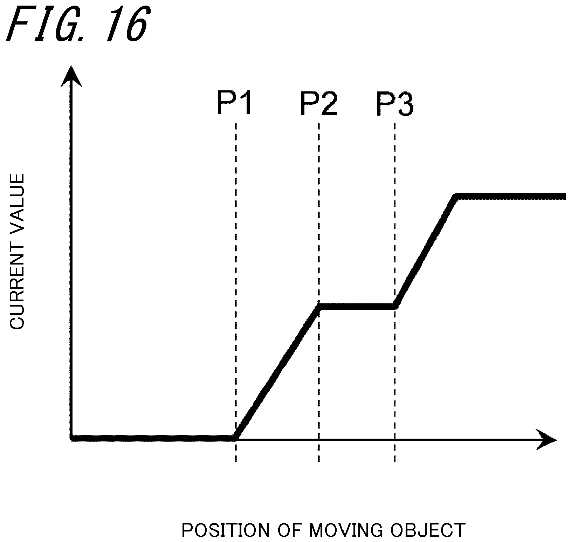

FIG. 16 represents, in graph form, general fluctuations of output values (current values) in the light-receiving device 19 as observed during the passage of the moving object 33. In what follows, the moving object 33 is illustrated as moving in a positive direction along the X axis shown in FIG. 15, and, the abscissa axis of the graph shown in FIG. 16 corresponds to the X axis shown in FIG. 15.

In the above-described case, at first, an output from the light-receiving device 19 starts to rise when the moving object 33 comes to reach the first one of the active layers 7 (Point P1 as shown in FIG. 16). Subsequently, when the moving object 33 comes to reach between the first one of the active layers 7 and the second one of the active layers 7 (Point P2 as shown in FIG. 16), the gradient of the rise of the output from the light-receiving device 19 decreases once. When the moving object 33 comes to reach the second one of the active layers 7 (Point P3 as shown in FIG. 16), the gradient of the rise of the output from the light-receiving device 19 increases once again.

That is, the presence of the first electrode 9 between the plurality of active layers 7 constitutes a low-light area of the light-emitting device 1. Hence, the gradient of the output value of the light-receiving device 19 as observed during the passage of the moving object 33 between the plurality of active layers 7 is smaller than the gradient of the output value of the light-receiving device 19 as observed during the passage of the moving object through each of the plurality of active layers 7. In other words, when the gradient of a certain output value of the light-receiving device 19 becomes smaller than gradients before and after the gradient of the certain output value, it means that the moving object passes through between the plurality of active layers 7.

Thus, by virtue of the plurality of active layers 7 provided in the light-emitting device of the optical sensor 1, it is possible to grasp the position of the moving object 33 in small increments, and thereby increase the position recognition accuracy of the moving object 33 by the optical sensor 1. For example, when the optical sensor 1 according to the present embodiment is mounted on an image forming apparatus, it is useful for registration of respective colors in color matching.

The light-emitting device 1 of the optical sensor 1 may comprise the plurality of first active layers 71A and the plurality of second active layers 72B. Now, consideration will be given to output fluctuations in the light-receiving device 19 as observed when the moving object 33 shaped diagonally with respect to the second direction D passes over the plurality of active layers 7, and also the plurality of first active layers 71A and the plurality of second active layers 72B are operated to emit light in alternate order. The following description deals with the case where, in the light receiving and emitting device module 18, the plurality of first active layers 71A are two first active layers 71A, and the plurality of second active layers 72B are two second active layers 72B.

In the above-described case, out of outputs from the light-receiving device 19, the output corresponding to the plurality of first active layers 71A (hereafter referred to as "first output") and the output corresponding to the plurality of second active layers 72B (hereafter referred to as "second output") are each similar in fluctuation to the output value described with reference to FIG. 16. Upon a difference between the first output and the second output, for example, when the second output is smaller than the first output, it is determined that the moving object 33 reaches the plurality of first active layers 71A prior to the plurality of second active layers 72B. On the other hand, for example, when the first output is smaller than the second output, it is determined that the moving object 33 reaches the plurality of second active layers 72B prior to the plurality of first active layers 71A.

Thus, by providing the plurality of first active layers 71A and the plurality of second active layers 72B in the optical sensor 1, it is possible to detect changes in the fourth direction D4 which is perpendicular to the third direction D3 (in the present embodiment, the fourth direction D4 coincides with the second direction D2).

Moreover, in the above-described case, for example, the moving object 33 may be intentionally placed so that it will not pass over the plurality of second active layers 72, and, in this case, positional control in the fourth direction can be exercised by checking that the second output is set at zero.

The optical sensor 1 may comprise a plurality of light-receiving devices 19. Consequently, for example, in contrast to the case where the first output and the second output are each derived from one light-receiving device 19, the light-receiving devices 19 can be configured to correspond to the first output and the second output, respectively, and this makes it possible to monitor the first output and the second output on an intermittent basis. Accordingly, the positional recognition accuracy of the optical sensor 1 can be increased.

In the case where the optical sensor 1 comprises two first active layers 71A and two second active layers 72B, the plurality of active layers 7 may be configured to emit light one after another in a clockwise direction or a counterclockwise direction.

It should be understood that the light emitting device, the light receiving and emitting device module, and the optical sensor according to the invention are not limited to the embodiments described heretofore, and that various changes, modifications, and improvements are possible without departing from the scope of the invention. Moreover, structural features as set forth in the individual embodiments may be used in combination on an as needed basis.

For example, the optical sensor 1 has been illustrated as being applied to an image forming apparatus, the application of the optical sensor 1 is not limited to the image forming apparatus. The optical sensor 1 can be applied as long as it reflects light by applying light, and, for example, the optical sensor 1 can be used for surface roughness measurement on a metallic molded product or a tablet. In this case, the irradiation target is the metallic molded product or the tablet.

**Claims**

1. A light-emitting device (1), comprising:

at least one first semiconductor layer (6) of one conductivity type;

a plurality of first active layers (7) laminated on the at least one first semiconductor layer, the plurality of first active layers being aligned in a first direction (D1);

a plurality of second active layers (7), each being arranged adjacent to corresponding one of the plurality of first active layers in a second direction (D2) which is perpendicular to the first direction;

a plurality of second semiconductor layers (8) of another conductivity type, the plurality of second semiconductor layers being laminated on the plurality of first active layers; and

a plurality of electrodes (9,10) connected to the at least one first semiconductor layer and the plurality of second semiconductor layers, the plurality of electrodes comprising at least one first electrode (9) disposed on the at least one first semiconductor layer (12) so as to lie between the plurality of first active layers, and a plurality of second electrodes (10) disposed on the plurality of second semiconductor layers,

some electrodes (10a, 10b) of the plurality of electrodes being opposed to each other, with the plurality of first active layers lying in between,

the other electrodes (9b) of the plurality of electrodes being located in a region between the some electrodes of the plurality of electrodes,

**characterised in that** a distance between the plurality of first active layers is longer than a distance between each of the plurality of first active layers and a corresponding one of the plurality of second active layers.

2. The light-emitting device according to claim 1, wherein the at least one first electrode (9) has a linear form, and the plurality of second electrodes (10) includes a plurality of principal portions (10a) each extending in an elongation direction of the at least one first electrode, and an extended portion (10b) extending from each of the plurality of principal portions toward the at least one first electrode.

3. The light-emitting device according to claim 1 or 2, wherein the plurality of second electrodes (10) are electrically independent of each other.

4. A light receiving and emitting device module (18), comprising:

the light-emitting device according to any one of claims 1 to 3; and

at least one light-receiving device (19).

5. An optical sensor, comprising:

a light receiving and emitting device module (18) according to claim 4; and

a mount located so as to face a light-emitting section of the light receiving and emitting device module.

6. The optical sensor according to claim 5, wherein the mount comprises a conveyer (32),

a conveyance surface of the conveyer faces the light-emitting section of the light receiving and emitting device module, and

the light receiving and emitting device module is disposed so that a conveyance direction of the conveyer and a second direction perpendicular to a first direction intersect each other.

**Patentansprüche**

1. Lichtemittierende Vorrichtung (1), aufweisend:

mindestens eine erste Halbleiterschicht (6) eines Leitfähigkeitstyps,

eine Mehrzahl von ersten aktiven Schichten (7), die auf die mindestens eine erste Halbleiterschicht laminiert sind, wobei die Mehrzahl von ersten aktiven Schichten in einer ersten Richtung (D1) ausgerichtet ist,

eine Mehrzahl von zweiten aktiven Schichten (7), die jeweils benachbart zu einer entsprechenden der Mehrzahl von ersten aktiven Schichten in einer zweiten Richtung (D2) angeordnet sind, die senkrecht zu der ersten Richtung ist,

eine Mehrzahl von zweiten Halbleiterschichten (8) eines anderen Leitfähigkeitstyps, wobei die Mehrzahl von zweiten Halbleiterschichten auf die Mehrzahl von ersten aktiven Schichten laminiert ist, und

eine Mehrzahl von Elektroden (9, 10), die mit der mindestens einen ersten Halbleiterschicht und der Mehrzahl von zweiten Halbleiterschichten verbunden sind, wobei die Mehrzahl von Elektroden mindestens eine erste Elektrode (9), die auf der mindestens einen ersten Halbleiterschicht (12) angeordnet ist, um zwischen der Mehrzahl von ersten aktiven Schichten zu liegen, und eine Mehrzahl von zweiten Elektroden (10), die auf der Mehrzahl von zweiten Halbleiterschichten angeordnet ist, aufweist,

wobei einige Elektroden (10a, 10b) der Mehrzahl von Elektroden einander gegenüberliegen, wobei die Mehrzahl von ersten aktiven Schichten dazwischen liegt,

wobei die anderen Elektroden (9b) der Mehrzahl von Elektroden in einem Bereich zwischen den einigen Elektroden der Mehrzahl von Elektroden angeordnet sind,

**dadurch gekennzeichnet, dass** ein Abstand zwischen der Mehrzahl von ersten aktiven Schichten länger als ein Abstand zwischen jeder der Mehrzahl von ersten aktiven Schichten und einer entsprechenden der Mehrzahl von zweiten aktiven Schichten ist.

2. Lichtemittierende Vorrichtung gemäß Anspruch 1, wobei die mindestens eine erste Elektrode (9) eine lineare Form hat und

die Mehrzahl von zweiten Elektroden (10) eine Mehrzahl von Hauptabschnitten (10a), die sich jeweils in einer Längenrichtung der mindestens einen ersten Elektrode erstrecken, und einen Erstreckungsabschnitt (10b), der sich von jedem der Mehrzahl von Hauptabschnitten in Richtung zu der mindestens einen ersten Elektrode erstreckt, aufweist.

3. Lichtemittierende Vorrichtung gemäß Anspruch 1 oder 2, wobei die Mehrzahl von zweiten Elektroden (10) elektrisch unabhängig voneinander ist.

4. Lichtempfangs- und -emissionsvorrichtungsmodul (18), aufweisend:

die lichtemittierende Vorrichtung gemäß irgendeinem der Ansprüche 1 bis 3 und
mindestens eine Lichtempfangsvorrichtung (19).

5. Optischer Sensor, aufweisend:

ein Lichtempfangs- und -emissionsvorrichtungsmodul (18) gemäß Anspruch 4 und
eine Halterung, die angeordnet ist, um einem lichtemittierenden Abschnitt des Lichtempfangs- und -emissionsvorrichtungsmoduls zugewandt zu sein.

6. Optischer Sensor gemäß Anspruch 5, wobei die Halterung eine Fördereinrichtung (32) aufweist,
eine Förderfläche der Fördereinrichtung dem lichtemittierenden Abschnitt des Lichtempfangs- und -emissionsvorrichtungsmoduls zugewandt ist und
das Lichtempfangs- und -emissionsvorrichtungsmodul derart angeordnet ist, dass eine Förderrichtung der Fördereinrichtung und eine zweite Richtung, die senkrecht zu einer ersten Richtung ist, einander schneiden.

**Revendications**

1. Dispositif électroluminescent (1), comprenant :

au moins une première couche semi-conductrice (6) d'un type de conductivité,
une pluralité de premières couches actives (7) laminées sur ladite au moins une première couche semi-conductrice, ladite pluralité de premières couches actives étant alignées dans une première direction (D1),
une pluralité de deuxièmes couches actives (7) disposées chacune de façon adjacente à une couche correspondante de la pluralité de premières couches actives dans une deuxième direction (D2) perpendiculaire à la première direction,
une pluralité de deuxièmes couches semi-conductrices (8) d'un type de conductivité différent, ladite pluralité de deuxièmes couches semi-conductrices étant stratifiées sur ladite pluralité de premières couches actives, et
une pluralité d'électrodes (9, 10) connectées à ladite au moins une première couche semi-conductrice et à ladite pluralité de deuxièmes couches semi-conductrices, ladite pluralité d'électrodes comprenant au moins une première électrode (9) disposée sur ladite au moins une première couche semi-conductrice (12) de manière à se trouver entre ladite pluralité de premières couches actives et une pluralité de deuxièmes électrodes (10) disposées sur ladite pluralité de deuxièmes couches semi-conductrices,
dans lequel quelques électrodes (10a, 10b) de ladite pluralité d'électrodes sont opposées les unes aux autres, avec ladite pluralité de premières couches actives entre elles,
dans lequel les autres électrodes (9b) de ladite pluralité d'électrodes sont disposées dans une région entre lesdites quelques électrodes de ladite pluralité d'électrodes,

**caractérisé en ce qu'**une distance entre la pluralité de premières couches actives est plus longue qu'une distance entre chacune de la pluralité de premières couches actives et une couche correspondante de la pluralité de deuxièmes couches actives.

2. Dispositif électroluminescent selon la revendication 1, dans lequel ladite au moins une première électrode (9) présente une forme linéaire, et

   ladite pluralité de deuxièmes électrodes (10) comprennent une pluralité de parties principales (10a) s'étendant chacune dans une direction de la longueur de ladite au moins une première électrode, et une partie d'extension (10b) s'étendant à partir de chacune de ladite pluralité de parties principales vers ladite au moins une première électrode.

3. Dispositif électroluminescent selon la revendication 1 ou 2, dans lequel ladite pluralité de deuxièmes électrodes (10) sont électriquement indépendantes les unes des autres.

4. Module de dispositif de réception et d'émission de lumière (18), comprenant :

   le dispositif électroluminescent selon l'une quelconque des revendications 1 à 3, et
   au moins un dispositif de réception de lumière (19).

5. Capteur optique, comprenant :

   un module de dispositif de réception et d'émission de lumière (18) selon la revendication 4 et
   un support disposé de manière à faire face à une partie émettrice de lumière du module de dispositif de réception et d'émission de lumière.

6. Capteur optique selon la revendication 5, dans lequel le support comprend un dispositif de transport (32),
   une surface de transport du dispositif de transport fait face à la section émettrice de lumière du module de dispositif de réception et d'émission de lumière, et
   le module de dispositif de réception et d'émission de lumière est disposé de telle sorte qu'une direction de transport du dispositif de transport et une deuxième direction perpendiculaire à une première direction se croisent.

*FIG. 1*

FIG. 2

FIG. 3

FIG. 4

# FIG. 5

1B

10Bb(10B)

D2

D1

15(8)

12

16

17

4

9B

10Bb(10B)

Y

Z ⊙ → X

10a(10B)

# FIG. 6

1B

D2

D1

71B
(7B)

72B
(7B)

12(6)

12(6)

12(6)

12(6)

71B
(7B)

72B
(7B)

4

Y

Z ⊙ → X

# FIG. 7

# FIG. 8

6C(12C)

1C

6C(12C)

7C

7C

6C(12C)   7C

7C   6C(12C)

Y

Z ⊙ ⟶ X

22

# FIG. 9

# FIG. 10

# FIG. 11

# FIG. 12

# FIG. 13

1E

12(6)

7

7

12(6)

7

7

Y

Z ⊙ → X

# FIG. 14

# FIG. 15

D1,D3 ⟷ ⊙ D2,D4

FIG. 16

# FIG. 17

# FIG. 18

**REFERENCES CITED IN THE DESCRIPTION**

**Patent documents cited in the description**

- JP 2007281426 A

- KR 20110098600